(19) Europäisches Patentamt
European Patent Office
Office européen des brevets

(11) **EP 4 439 101 A1**

(12) **EUROPEAN PATENT APPLICATION**

(43) Date of publication:
**02.10.2024 Bulletin 2024/40**

(21) Application number: **23165782.6**

(22) Date of filing: **31.03.2023**

(51) International Patent Classification (IPC):
***G01R 31/319*** (2006.01)   ***G01R 31/28*** (2006.01)
***G01R 29/08*** (2006.01)

(52) Cooperative Patent Classification (CPC):
**G01R 31/2844; G01R 29/0821; G01R 31/2862;
G01R 31/31905**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **kiutra GmbH
81369 München (DE)**

(72) Inventors:
• **Spallek, Jan
81369 Munich (DE)**
• **Rucker, Felix
81369 Munich (DE)**
• **Bachus, Sebastian
81369 Munich (DE)**

(74) Representative: **Legl, Stefan
LLM IP Patentanwaltskanzlei
Hofmannstrasse 60
81379 München (DE)**

(54) **APPARATUS FOR TESTING AND/OR OPERATING ELECTRONIC DEVICES**

(57)    The present disclosure relates to an apparatus (100, 200) for testing and/or operating electronic devices (10), preferably inside a cryogenic apparatus (1000). The apparatus (100, 200) includes a base (110) having a base surface (112) configured to have at least one electronic device (10) arranged thereon; an electrically conductive chamber (120) surrounding the base surface (112); and a needle card (130) including at least one contact needle (132), the at least one contact needle (132) being configured for electrical contact with the at least one electronic device (10) for testing and/or operating the at least one electronic device (10).

**Fig. 2**

<u>100</u>

## Description

### FIELD

The present disclosure relates to an apparatus for testing and/or operating electronic devices, a cryogenic system, and a method for testing and/or operating electronic devices. More particularly, the present disclosure relates to testing and/or operating high-frequency electronics inside a cryogenic apparatus under defined thermal conditions, e.g., at ultra-low temperatures in the sub-Kelvin or milli-Kelvin range.

### BACKGROUND

Electrical testing of conductive, semiconductive, superconductive, quantum dot based, electromechanical and/or electrooptical circuits, which are often deposited as thin films on a substrate by various processes, requires that they be electrically contacted. For small quantities, easily accessible structures and less demanding test regimes, these structures are bonded. For this purpose, thin metal wires are fused to pads that are part of the structure, often by applying electric current. The bonds are permanent and can be fragile, especially to mechanical stress.

To avoid the problems associated with bonding, so-called needle cards can be used. Here, one or more needles are placed and pressed onto the structure with a defined force, creating an electrical connection. However, the use of needle cards is sometimes not possible, especially in the high-frequency and low-power range, due to signal losses caused by radiation into the surroundings.

In view of the above, new apparatuses for testing and/or operating electronic devices, cryogenic systems, and methods for testing and/or operating electronic devices, that overcome at least some of the problems in the art are beneficial.

### SUMMARY

It is an object of the present disclosure to provide an apparatus for testing and/or operating electronic devices, a cryogenic system, and a method for testing and/or operating electronic devices that can prevent signal loss during testing and/or operating electronic devices. Another object of the present disclosure is to enable the use of needle cards in the high-frequency and/or low-power regime.

According to an independent aspect of the present disclosure, an apparatus for testing and/or operating electronic devices, preferably inside a cryogenic apparatus, is provided. The apparatus includes a base having a base surface configured to have at least one electronic device arranged thereon; an electrically conductive chamber surrounding the base surface; and a needle card including at least one contact needle, the at least one contact needle being configured for electrical contact with the at least one electronic device for testing and/or operating the at least one electronic device.

The term "needle card" as used throughout the present disclosure refers to an interface between the at least one electronic device and a testing and/or operating equipment. One purpose of the needle card is to provide an electrical path between the testing and/or operating equipment and the at least one electronic device via the at least one contact needle, thereby permitting the testing and/or operation of the at least one electronic device. In some embodiments, the needle card may also be referred to as a "probe card".

According to some embodiments, which can be combined with other embodiments described herein, the contact needle is an elongated and slender object having a tip configured for electrical contact with the at least one electronic device. The tip may be a sharp-pointed tip or may have any other shape suitable to electrically contact the at least one electronic device.

According to some embodiments, which can be combined with other embodiments described herein, the at least one contact needle is configured for a reversible electrical contact with the at least one electronic device for testing and/or operating the at least one electronic device.

The term "reversible" as used throughout the present disclosure refers to the ability to break or terminate the electrical contact by, for example, moving the contact needle and the electronic device away from each other without applying a mechanical or other force to break the connection between the contact needle and the electronic device, and thus without damaging the contact needle and/or the electronic device.

According to some embodiments, which can be combined with other embodiments described herein, the needle card is arranged outside of the electrically conductive chamber.

According to some embodiments, which can be combined with other embodiments described herein, the electrically conductive chamber includes at least one opening in a chamber wall thereof.

Preferably, the at least one contact needle extends through the at least one opening of the electrically conductive chamber to contact the at least one electronic device arranged in an interior or cavity of the electrically conductive chamber.

According to some embodiments, which can be combined with other embodiments described herein, the electrically conductive chamber has an electromagnetic eigenmode that is larger than a testing and/or operating frequency supplied to the at least one electronic device via the at least one contact needle during testing and/or operating of the at least one electronic device. This can prevent signal loss during testing and/or operation of the electronic device, since the testing and/or operating frequency is not sufficient to cause a standing wave excitation state corresponding to the electromagnetic eigenmode inside the electrically conductive chamber.

The electromagnetic eigenmode is an eigenmode of an interior space or cavity of the electrically conductive chamber and is defined by dimensions of said interior space or cavity (e.g., x-, y- and z-dimensions).

Given a three-dimensional interior or cavity of the electrically conductive chamber, the electromagnetic eigenmodes of the interior or cavity of the electrically conductive chamber can be three-dimensional electromagnetic eigenmodes. The electromagnetic eigenmodes can be denoted by triplets $[l,m,n]$, where $l$, $m$ and $n$ are natural numbers used to identify the mode in three dimensions. In particular, the electromagnetic eigenmodes can be identified by triplets corresponding to permutations of 0 and 1, e.g., [1,0,0], [0,1,0], [0,0,1], [1,1,0], etc.

In some embodiments, for a given geometry of the interior or cavity of the electrically conductive chamber, electromagnetic eigenmodes can be determined by considering all triplet permutations, wherein the lowest electromagnetic eigenmode of the triplet permutations defines a lowest possible excitation frequency or dominant mode. The testing and/or operating frequency can be selected to be lower than this lowest possible excitation frequency or dominant mode. This can prevent signal loss during testing and/or operation of the electronic device, since the testing and/or operating frequency is not sufficient to cause a standing wave excitation state corresponding to the lowest possible excitation frequency or dominant mode.

In some embodiments, the geometry of the interior or cavity of the electrically conductive chamber can be configured such that the lowest possible excitation frequency or dominant mode is larger than the testing and/or operating frequency. In particular, the testing and/or operating frequency may be specified or given, for example, by the field of use, and the geometry of the interior or cavity of the electrically conductive chamber can be configured such that the lowest possible excitation frequency or dominant mode is larger than the testing and/or operating frequency.

Preferably, the electromagnetic eigenmode of the electrically conductive chamber is 50GHz or more, 80GHz or more, or 100GHz or more. In some embodiments, the electromagnetic eigenmode of the electrically conductive chamber can be in a range between 10GHz and 100GHz, preferably in a range between 20GHz and 800GHz.

According to some embodiments, which can be combined with other embodiments described herein, the testing and/or operating frequency supplied to the at least one electronic device via the at least one contact needle during testing and/or operating of the at least one electronic device is a radiofrequency (RF). Radiofrequency fields fall within a portion of the electromagnetic spectrum with frequencies ranging from, for example, 3kHz to 300GHz.

Preferably, the testing and/or operating frequency is 100GHz or less, 80GHz or less, or 50GHz or less. In some embodiments, the testing and/or operating frequency can be in a range between 10GHz and 100GHz, preferably in a range between 20GHz and 800GHz.

According to some embodiments, which can be combined with other embodiments described herein, the electrically conductive chamber is further configured as an electrical shield to shield the at least one electronic device from external electrical interference. In some embodiments, the electrically conductive chamber is configured as a radiofrequency shield.

According to some embodiments, which can be combined with other embodiments described herein, the electrically conductive chamber includes, or is made of, at least one electrically conductive material.

In one example, the electrically conductive chamber is made of the at least one electrically conductive material. In another example, the electrically conductive chamber includes a base material and is covered or coated with the at least one electrically conductive material. The base material may be an electrically conductive base material or may be an electrically insulating base material.

Preferably, the at least one electrically conductive material is selected from the group including, or consisting of, aluminum (Al), copper (Cu), titanium (Ti), and niobium (Nb).

According to some embodiments, which can be combined with other embodiments described herein, a void space is provided between the at least one contact needle extending through the at least one opening and an edge of the at least one opening. The void space is understood as a space essentially devoid of matter. In particular, there may not be any other material in the opening between the at least one contact needle and the edge of the at least one opening so that the at least one contact needle is freely moveable within the at least one opening.

According to further embodiments, which can be combined with other embodiments described herein, a bridging material is provided between the at least one contact needle extending through the at least one opening and an edge of the at least one opening. In particular, the bridging material may fix the at least one contact needle inside the at least one opening and/or to the edge of the at least one opening so that the at least one contact needle is unmovable within the at least one opening.

Preferably, the bridging material is an electrically insulating material.

According to some embodiments, which can be combined with other embodiments described herein, the at least one contact needle is covered with an insulating material with a tip of the at least one contact needle being exposed.

According to further embodiments, which can be combined with other embodiments described herein, the at least one contact needle is not covered with any material, such as an insulating material. In other words, an electrically conductive material forming the at least one contact needle can be uncovered and thus exposed.

According to some embodiments, which can be combined with other embodiments described herein, the at least one opening of the electrically conductive chamber is a plurality of openings and the at least one contact needle is a plurality of contact needles, wherein each contact needle of the plurality of contact needles extends through a respective opening of the plurality of openings. In other words, one contact needle of the needle card extends through one opening of the electrically conductive chamber.

According to some embodiments, which can be combined with other embodiments described herein, a number of openings of the electrically conductive chamber is equal to a number of contact needles of the needle card. Alternatively, the number of openings of the electrically conductive chamber can be different from the number of contact needles of the needle card, e.g., higher or smaller.

According to some embodiments, which can be combined with other embodiments described herein, the at least one opening includes, or is, at least one slot in the chamber wall.

Preferably, the at least one slot is open at a portion of the chamber wall facing the base surface.

Preferably, the at least one slot is a plurality of slots arranged along a circumference of the chamber wall. For example, the plurality of slots may form a comb-like structure.

Preferably, the plurality of slots are arranged along the circumference of the chamber wall at regular or irregular intervals.

According to some embodiments, which can be combined with other embodiments described herein, the electrically conductive chamber is releasably (or detachably) attachable to the base, e.g., the base surface.

According to some embodiments, which can be combined with other embodiments described herein, the chamber wall includes a lateral chamber wall and a top chamber wall arranged on a first side of the lateral chamber wall, wherein the lateral chamber wall and the top chamber wall define an interior (e.g., a cavity) of the electrically conductive chamber.

Preferably, the top chamber wall is arranged to face the needle card.

Preferably, the lateral chamber wall and the top chamber wall define a cup-shape.

Preferably, the lateral chamber wall has a cylindrical shape. The term "cylinder" can be understood as commonly accepted as having a circular bottom shape and a circular upper shape and a curved surface area or shell connecting the upper circle and the little lower circle.

Preferably, the electrically conductive chamber has an opening at a second side of the lateral chamber wall opposite the first side of the lateral chamber wall.

Preferably, the second side of the lateral chamber wall is attachable or attached to the base or base surface to close off the interior of the electrically conductive chamber,

Preferably, the at least one opening is provided in the lateral chamber wall and/or the top chamber wall.

According to some embodiments, which can be combined with other embodiments described herein, the needle card includes a base structure arranged outside the electrically conductive chamber, wherein the at least one contact needle is attached to the base structure and extends from the base structure through the at least one opening in the chamber wall of the electrically conductive chamber.

Preferably, the base structure of the needle card includes a base ring and/or a circuit board.

Preferably, the at least one contact needle extends from an inner sidewall of the base ring.

Preferably, the base ring is a ceramic ring.

Preferably, the circuit board is a printed circuit board (PCB).

According to some embodiments, which can be combined with other embodiments described herein, the base of the apparatus includes a recess, a bottom of the recess providing the base surface on which the electronic device can be disposed.

Preferably, the recess is further configured to accommodate the needle card, particularly the base structure or base ring of the base structure.

Preferably, the recess is further configured to accommodate the electrically conductive chamber. For example, the electrically conductive chamber may be disposed inside the base ring of the needle card.

According to some embodiments, which can be combined with other embodiments described herein, the at least one electronic device is selected from the group including, or consisting of, an integrated circuit, a quantum chip, a wafer, a semiconductor device, a component of an integrated circuit, and a component of quantum chip. However, the present disclosure is not limited thereto, and the at least one electronic device can be any electronic device suitable for testing and/or operating with a needle card, such as any conductive, semiconductive, superconductive, quantum dot based, electromechanical and/or electrooptical circuit. In particular, the at least one electronic device can be any sub-component of an integrated circuit, such as a transistor, transformer, and the like.

According to some embodiments, which can be combined with other embodiments described herein, the apparatus for testing and/or operating electronic devices is connectable to a cryogenic apparatus for testing and/or operating of the at least one electronic device.

According to some embodiments, which can be combined with other embodiments described herein, the apparatus for testing and/or operating electronic devices is releasably or detachably connectable to the cryogenic apparatus.

According to some embodiments, which can be combined with other embodiments described herein, the apparatus for testing and/or operating electronic devices can be insertable into the cryogenic apparatus for testing and/or operating of the at least one electronic device. For example, the apparatus for testing and/or operating electronic devices can be loaded into a vacuum chamber of the cryogenic apparatus for testing and/or operating of the at least one electronic device under defined thermal conditions, such as 4K or lower.

In some embodiments, the apparatus, particularly the needle card and/or electrically conductive chamber, can be configured or optimized for operation at temperatures below 4K. In particular, the materials of the needle card and/or the electrically conductive chamber can be selected based on their thermal properties, such as thermal conductivity. Additionally or alternatively, thermal coupling of some or all of the components of the apparatus may be provided to enable reliable operation of the apparatus at temperatures below 4K.

According to some embodiments, which can be combined with other embodiments described herein, the apparatus for testing and/or operating electronic devices is configured to be connected to an object holder that is connectable to and/or insertable into the cryogenic apparatus. The object holder can be a puck or similar device which can be attached to an object stage inside the cryogenic apparatus.

Preferably, the apparatus for testing and/or operating electronic devices is releasably or detachably connectable to the object holder.

According to another independent aspect of the present disclosure, a cryogenic apparatus is provided. The cryogenic apparatus includes a vacuum chamber, an object stage in the vacuum chamber, and a cooling arrangement configured to cool the object stage. The cryogenic apparatus can also be referred to as a cryostat.

A vacuum is generally understood as a space essentially devoid of matter. The term "vacuum" as used throughout the present application is in particular understood as a technical vacuum, i.e., a region with a gaseous pressure much less than atmospheric pressure. The vacuum inside the vacuum chamber can be high vacuum, ultra-high vacuum or extremely high vacuum (XHV). One or more vacuum generation sources, such as turbo pumps and/or cryo pumps and/or ion-getter pumps, can be connected to the vacuum chamber to generate the vacuum.

The apparatus for testing and/or operating electronic devices can be connectable, particularly releasably connectable, to the object stage for testing and/or operating of the at least one electronic device. In particular, a loading mechanism can be used to load the apparatus (or an object holder having the apparatus attached thereto) into and/or unload the apparatus (or the object holder having the apparatus attached thereto) from the cryogenic apparatus.

According to some embodiments, which can be combined with other embodiments described herein, the cryogenic apparatus can be configured to cool the object stage and/or the apparatus for testing and/or operating electronic devices and/or the at least one electronic device attached to the apparatus for testing and/or operating electronic devices.

According to some embodiments, which can be combined with other embodiments described herein, the cryogenic apparatus can be configured to cool the object stage and/or the apparatus for testing and/or operating electronic devices and/or the at least one electronic device attached to the apparatus for testing and/or operating electronic devices to a temperature in range between 1mK and 300K, particularly in a range between 1mK and 4K.

According to some embodiments, which can be combined with other embodiments described herein, the cryogenic apparatus can be configured to control a temperature of the object stage and/or the apparatus for testing and/or operating electronic devices and/or the at least one electronic device attached to the apparatus for testing and/or operating electronic devices within a predetermined temperature range. The predetermined temperature range may be 5mK to 0.5K, particularly 5mK to 1K, particularly 5mK to 4K, particularly 5mK to 10K, particularly 5mK to 100K, and more particularly 5mK (or 50mK or 100mK or 300mK) to 300K (e.g., room temperature).

The term "temperature of the object stage and/or the apparatus for testing and/or operating electronic devices and/or the at least one electronic device attached to the apparatus for testing and/or operating electronic devices" may refer to an actual temperature of the object stage and/or the apparatus for testing and/or operating electronic devices and/or the at least one electronic device attached to the apparatus for testing and/or operating electronic devices as measured, for example, by one or more thermometers attached to the obj ect stage and/or the apparatus for testing and/or operating electronic devices and/or the at least one electronic device attached to the apparatus for testing and/or operating electronic devices, such as resistive NTC thermometers. In some embodiments, the temperature of the object stage and/or the apparatus for testing and/or operating electronic devices and/or the at least one electronic device attached to the apparatus for testing and/or operating electronic devices can be a target temperature which is to be achieved and stably maintained and/or controlled by the cryogenic apparatus.

According to some embodiments, which can be combined with other embodiments described herein, the cooling arrangement includes a cryogen-free system, such as a cryogen-free closed cycle system.

According to some embodiments, which can be combined with other embodiments described herein, the cooling arrangement includes a pulse tube cryocooler and/or an adiabatic demagnetization refrigerator and/or a Gifford-McMahon cryocooler and/or a Peltier cooler.

According to some embodiments, which can be combined with other embodiments described herein, the object stage includes at least one first electrical interface connectable to at least one second electrical interface of the apparatus for testing and/or operating electronic devices, for instance via the object holder. In particular, the electrical interfaces may allow for an electrical connection between the needle card (and thus the at least one electronic device) and testing and/or operating equipment which may be located outside the cryogenic apparatus.

Preferably, the at least one first electrical interface and at least one second electrical interface may include at least one of a DC interface and an RF interface.

According to another independent aspect of the present disclosure, an electrically conductive chamber used in testing and/or operating electronic devices e.g. inside a cryogenic apparatus is provided. The electrically conductive chamber includes a cavity configured to accommodate at least one electronic device therein; and a chamber wall defining the cavity and having at least one opening configured to receive at least one contact needle of a needle card arranged outside of the electrically conductive chamber.

Preferably, the cavity has an electromagnetic eigenmode that is larger than a testing and/or operating frequency supplied to the at least one electronic device via the at least one contact needle during testing and/or operating of the at least one electronic device. The electromagnetic eigenmode can be a lowest possible frequency or dominate mode defined by a geometry of the cavity.

The electrically conductive chamber can be the electrically conductive chamber of the apparatus for testing and/or operating electronic devices described above.

According to another independent aspect of the present disclosure, a cryogenic system is provided. The cryogenic system includes the cryogenic apparatus and the apparatus for testing and/or operating electronic devices of the embodiments of the present disclosure.

According to another independent aspect of the present disclosure, a method for testing and/or operating electronic devices is provided, preferably inside a cryogenic apparatus. The method includes testing and/or operating at least one electronic device mounted to the apparatus for testing and/or operating electronic devices of the embodiments of the present disclosure.

According to some embodiments, which can be combined with other embodiments described herein, the method includes supplying at least one testing and/or operating signal having a testing and/or operating frequency to the at least one electronic device via the at least one contact needle to test and/or operate the at least one electronic device.

According to embodiments described herein, the method for testing and/or operating electronic devices can be conducted by means of computer programs, software, computer software products and the interrelated controllers, which can have a CPU, a memory, a user interface, and input and output means being in communication with the corresponding components of the apparatus for testing and/or operating electronic devices and/or the cryogenic apparatus.

According to an independent aspect of the present disclosure, a machine readable medium (e.g., a memory) is provided. The machine-readable medium includes instructions executable by one or more processors to implement the embodiments of the method for testing and/or operating electronic devices of the present disclosure.

The (e.g., non-transitory) machine readable medium may include, for example, optical media such as CD-ROMs and digital video disks (DVDs), and semiconductor memory devices such as Electrically Programmable Read-Only Memory (EPROM), and Electrically Erasable Programmable Read-Only Memory (EEPROM). The machine-readable medium may be used to tangibly retain computer program instructions or code organized into one or more modules and written in any desired computer programming language. When executed by, for example, one or more processors such computer program code may implement one or more of the methods described herein.

According to an independent aspect of the present disclosure, a controller is provided. The controller includes one or more processors and a memory coupled to the one or more processors and comprising instructions executable by the one or more processors to implement the embodiments of the method of controlling a cryogenic apparatus of the present disclosure.

According to another independent aspect of the present disclosure, a cryogenic apparatus is provided. The cryogenic apparatus includes the above controller.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. It includes method aspects for carrying out every function of the apparatus.

Further aspects, benefits, and features of the present disclosure are apparent from the claims, the description, and the accompanying drawings.

**BRIEF DESCRIPTION OF THE DRAWINGS**

So that the manner in which the above recited features of the present disclosure can be understood in detail, a more particular description of the disclosure, briefly summarized above, may be had by reference to embodiments. The accompanying drawings relate to embodiments of the disclosure and are described in the following:

FIG. 1    shows a schematic view of a cryogenic apparatus according to the embodiments of the present disclosure;

FIG. 2    shows a schematic view of an apparatus for testing and/or operating electronic devices inside a cryogenic apparatus according to embodiments of the present disclosure;

FIG. 3    shows a schematic view of an apparatus for testing and/or operating electronic devices inside a cryogenic apparatus according to further embodiments of the present disclosure;

FIG. 4    shows a cross-sectional view of the apparatus of FIG. 3; and

FIG. 5    shows another cross-sectional view of the apparatus of FIGs. 3 and 4.

**DETAILED DESCRIPTION OF EMBODIMENTS**

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

Electrical testing of conductive, semiconductive and superconductive circuits, which are often deposited as thin films on a substrate by various processes, requires that they be electrically contacted. For small quantities, easily accessible structures and less demanding test regimes, these structures are bonded. For this purpose, thin metal wires are fused to pads that are part of the structure, often by applying electric current. The bonds are permanent and can be fragile, especially to mechanical stress. In addition, the use of needle cards is sometimes not possible, especially in the high-frequency and low-power range, due to signal losses caused by radiation into the surroundings.

The embodiments of the present disclosure overcome the above drawbacks by placing a needle card outside of an electrically conductive chamber and guiding contact needles of the needle card through openings in the electrically conductive chamber for contact with the electronic device located in a cavity defined by the electrically conductive chamber. By placing the needle card outside the electrically conductive chamber, the electrically conductive chamber can have smaller dimensions that increase an electromagnetic eigenmode of the electrically conductive chamber, such as a lowest possible excitation frequency. Additionally, it avoids adding materials of different electromagnetic characteristics for instance inside the cavity, negatively impacting the electromagnetic eigenmode. As a result, signal loss during testing and/or operation of the electronic device, particularly in the high frequency and/or low power range, can be avoided.

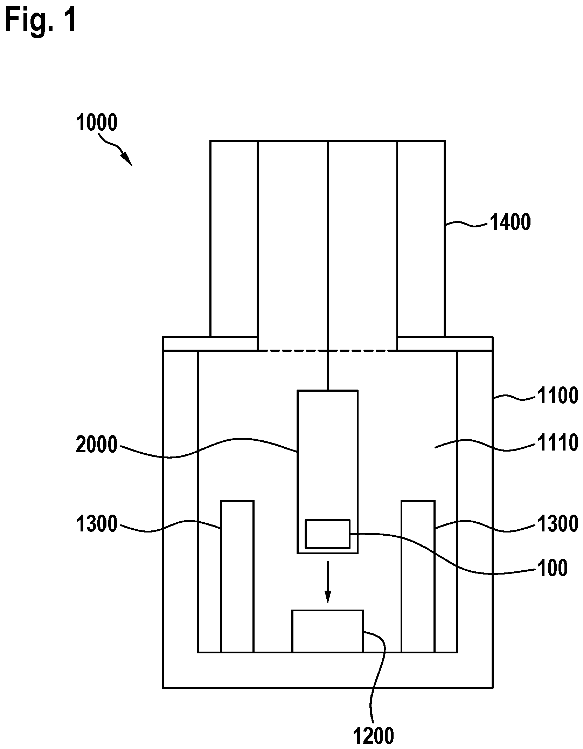

FIG.1 shows a schematic view of a cryogenic apparatus 1000 according to exemplary embodiments of the present disclosure. The cryogenic apparatus 1000 can be used to test and/or operate electronic devices under defined thermal conditions, e.g., at ultra-low temperatures in the sub-Kelvin or milli-Kelvin range, using the apparatus 100 for testing and/or operating electronic devices of the present disclosure.

The cryogenic apparatus 1000 includes a vacuum chamber 1100, an object stage 1200 in the vacuum chamber 1100, and a cooling arrangement configured 1300 to cool the object stage 1200.

The vacuum chamber 1100 has an interior space 1110 which is configured to contain a vacuum. The vacuum chamber 1100 seals the interior space 1110 from the outside essentially gas-tight, vacuum-tight, heat-impermeable, and/or radiation-impermeable. Optionally, the vacuum chamber 1100 may electrically insulate the interior space 1110 from the outside.

A vacuum is generally understood as a space essentially devoid of matter. The term "vacuum" as used throughout the present application is in particular understood as a technical vacuum, i.e., a region with a gaseous pressure much less than atmospheric pressure. The vacuum inside the vacuum chamber 1100 can be high vacuum or ultra-high vacuum. One or more vacuum generation sources, such as turbo pumps and/or cryo pumps (not shown), can be connected to the vacuum chamber 1100 to generate the vacuum.

The apparatus 100 for testing and/or operating electronic devices can be connectable, particularly releasably connectable, to the object stage 1200 for testing and/or operating the electronic device(s) under defined thermal conditions, e.g., at ultra-low temperatures in the sub-Kelvin or milli-Kelvin range. In particular, a loading mechanism 2000 can be used to load the apparatus 100 (or an object holder having the apparatus 100 attached thereto) into and/or unload the apparatus 100 (or the object holder having the apparatus 100 attached thereto) from the cryogenic apparatus 1000. The object holder can be a puck or similar device which can be attached to an object stage 1200 inside the cryogenic apparatus 1000.

According to some embodiments, the object stage 1200 includes at least one first electrical interface connectable to at least one second electrical interface of the apparatus 100 for testing and/or operating electronic devices, for instance via the object holder. In particular, the electrical interfaces may allow for an electrical connection between the apparatus 100 and testing and/or operating equipment which may be located outside the cryogenic apparatus 1000.

Preferably, the at least one first electrical interface and/or the at least one second electrical interface may include at least one of a DC interface and an RF interface.

The cryogenic apparatus 1000 may include an access port 1400 having an inner space and a vacuum lock. The vacuum lock may seal the interior space 1110 from the inner space of the access port 1400 essentially vacuum-tight in a closed state and may allow an access to the interior space 1110 in an open state.

For example, the vacuum lock can be closed and the object holder having the apparatus 100 attached thereto can be placed in the inner space of the access port 1400, e.g., under atmospheric pressure. The inner space of the access port 1400 can be sealed from the outside and a technical vacuum can be generated in the inner space. Then, the vacuum lock can be opened to connect the interior space 1110 of the vacuum chamber 1100 and the inner space of the access port 1400. The object holder having the apparatus 100 attached thereto can be inserted into the vacuum chamber 1100 using the transfer mechanism 2000. The object holder attached thereto can be mechanically attached to a base (e.g., including or being the object stage 1200), the object holder can be released from the transfer mechanism 2000, and the transfer mechanism 2000 can be removed from the inner space 1110. The vacuum lock can be closed and the cryogenic apparatus 1000 can be operated for testing and/or operating electronic devices.

The access port 1400 and/or the loading mechanism 2000 are optional though and other means to provide the apparatus 100 having an electronic device mounted thereon inside the cryogenic apparatus 1000 can be used.

According to some embodiments, the cryogenic apparatus 1000 can be configured to cool the apparatus 100 and thus the electronic device(s) mounted thereon using the cooling arrangement 1300. In particular, the cooling arrangement 1300 can be thermally connected to the object stage which in turn can be thermally connected to the apparatus 100. The thermal connection can be achieved using mechanical contact and suitable materials between the elements to cool the apparatus 100 and thus the electronic device(s) mounted thereon.

The cryogenic apparatus 1000 can be configured to cool the apparatus 100 and thus the electronic device(s) mounted thereon to temperatures in a range between 1mK and 300K, 5mK to 0.5K, particularly 5mK to 1K, particularly 5mK to 4K, particularly 5mK to 10K, particularly 5mK to 100K, and more particularly 5mK (or 50mK or 100mK or 300mK) to 300K (e.g., room temperature). In some implementations, even if the system is a cryostat, temperatures up to room temperature can be provided.

According to some embodiments, which can be combined with other embodiments described herein, the cryogenic apparatus 1000 includes, or is, an adiabatic demagnetization refrigerator, and in particular a multi-stage adiabatic demagnetization refrigerator. The multi-stage adiabatic demagnetization refrigerator may be configured to operate at 1K or below, particularly at 500mK or below, particularly at 100mK or below, and particularly at 50mK or below. However, as mentioned above, the present disclosure is not limited thereto and the cryogenic apparatus 1000 can be operated at higher temperatures, i.e., temperatures of 1K or higher, e.g., up to room temperature.

In the following, exemplary embodiments of the apparatus 100 for testing and/or operating electronic devices are described in detail.

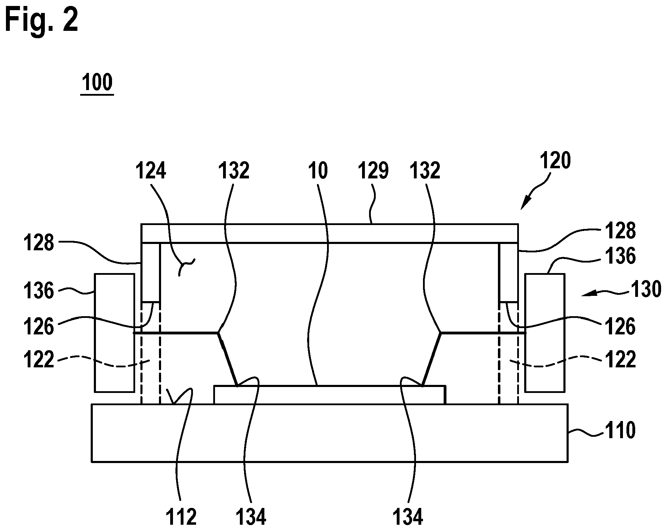

FIG. 2 shows a schematic view of an apparatus 100 for testing and/or operating electronic devices 10 inside a cryogenic apparatus according to embodiments of the present disclosure.

The apparatus 100 is connectable to the object stage of the cryogenic apparatus of FIG. 1 for testing and/or operating of at least one electronic device 10 mounted thereon under defined thermal conditions, such as 4K or lower. In particular, the apparatus 100 can be connected to an object holder that is connectable to and/or insertable into the cryogenic apparatus. The object holder can be a puck or similar device which can be attached to the object stage inside the vacuum chamber of the cryogenic apparatus.

It is understood that the apparatus 100 may be loaded into the cryogenic apparatus in the orientation shown in FIG. 2, or it may be loaded into the cryogenic apparatus upside down.

The apparatus 100 includes a base 110 (or support) having a base surface 112 (or support surface) configured to have at least one electronic device 10 arranged thereon. The at least one electronic device 10 can be selected from the group including, or consisting of, an integrated circuit, a quantum chip, a wafer, a semiconductor device, a component of an integrated circuit, and a component of quantum chip. However, the present disclosure is not limited thereto, and the at least one electronic device 10 can be any sub-component of an integrated circuit, such as a transistor, transformer, and the like.

The apparatus 110 further includes an electrically conductive chamber 120 surrounding the base surface 112 such that the at least one electronic device 10 is arranged in an interior or cavity 124 of the electrically conductive chamber 120. The apparatus 110 further includes a needle card 130 including at least one contact needle 132 configured for a reversible electrical contact with the at least one electronic device 10 for testing and/or operating the at least one electronic device 10.

The needle card 130 can be configured to provide an electrical path between testing and/or operating equipment and the at least one electronic device 10 via the at least one contact needle 132, thereby permitting the testing and/or operating of the at least one electronic device 10.

The at least one contact needle 132 is an elongated and slender object having a tip 134 configured for electrical contact with the at least one electronic device 10. The tip 134 may be a sharp-pointed tip or may have any other shape suitable to electrically contact the at least one electronic device 10.

The needle card 130 is arranged outside of the electrically conductive chamber 120. The at least one contact needle 132 extends through at least one opening 122 of the electrically conductive chamber 120 to contact the at least one electronic device 10 arranged in the interior or cavity 124 of the electrically conductive chamber 120.

The electrically conductive chamber 120 includes, or is made of, at least one electrically conductive material, such as aluminum (Al), copper (Cu), titanium (Ti), and niobium (Nb). In one example, the electrically conductive chamber 120 is made of the at least one electrically conductive material. In another example, the electrically conductive chamber 120 includes a base material and is covered or coated with the at least one electrically conductive material.

The electrically conductive chamber 120, in particular the interior or cavity 124 of the electrically conductive chamber 120, has an electromagnetic eigenmode. Preferably, the electromagnetic eigenmode of the electrically conductive chamber 120 is 50GHz or more, 80GHz or more, or 100GHz or more. In some embodiments, the electromagnetic eigenmode of the electrically conductive chamber 120 can be in a range between 10GHz and 100GHz, preferably in a range between 20GHz and 800GHz.

The electromagnetic eigenmode of the electrically conductive chamber 120 is larger than a testing and/or operating frequency supplied to the at least one electronic device 10 via the at least one contact needle 132 during testing and/or operating of the at least one electronic device 10. In other words, the testing and/or operating frequency supplied to the at least one electronic device 10 via the at least one contact needle 132 during testing and/or operating of the at least one electronic device 10 can be smaller than the electromagnetic eigenmode of the electrically conductive chamber 120.

Preferably, the testing and/or operating frequency is a radiofrequency (RF) and can be, for example, 100GHz or less, 80GHz or less, or 50GHz or less. In some embodiments, the testing and/or operating frequency can be in a range between 10GHz and 100GHz, preferably in a range between 20GHz and 800GHz.

The electromagnetic eigenmode (also referred to as "fundamental mode") of the electrically conductive chamber 120, particularly the interior or cavity 124 thereof, can be determined for a simple rectangular geometry using the following formular ($\omega_{l,m,n}$ denotes a frequency for each possible eigenmode):

$$\omega_{l,m,n} = \frac{c}{\sqrt{\mu_r \epsilon_r}} \sqrt{\left(\frac{l\pi}{X}\right)^2 + \left(\frac{m\pi}{Y}\right)^2 + \left(\frac{n\pi}{Z}\right)^2}$$

where $X$, $Y$ and $Z$ are the three cavity dimensions and $l$, $m$ and $n$ are natural numbers used to identify the mode, i.e., standing waves between opposite walls.

However, the present disclosure is not limited thereto and the electromagnetic eigenmode can be determined using, for example, suitable simulation tools (e.g., Ansys HFSS), particularly for more complex chamber geometries.

By placing the needle card 130 outside the electrically conductive chamber 120, the electrically conductive chamber 120 can have smaller dimensions that increase the electromagnetic eigenmode of the electrically conductive chamber 120. Additionally, it avoids adding materials of different electromagnetic characteristics for instance inside the cavity, negatively impacting the electromagnetic eigenmode. As a result, signal loss during testing and/or operation of the electronic device 10, particularly in the high frequency and/or low power range, can be avoided.

Optionally, the electrically conductive chamber 120 can be further configured as an electrical shield to shield the at least one electronic device 10 from external electrical interference. For example, the electrically conductive chamber 120 can be configured as a radiofrequency shield.

In some embodiments, the needle card 130 includes a base structure 136 arranged outside the electrically conductive chamber 120. The base structure 136 can have a ring-shape and at least partially surround the electrically conductive chamber 120. The at least one contact needle 132 can be attached to the base structure 136 and extend from the base structure 136 through the at least one opening 122 to contact the at least one electronic device 10. In particular, a first end of the at least one contact needle 132 can be attached to the base structure 136 (e.g., a circuit board of the base structure 136). A second end of the at least one contact needle 132 opposite the first end includes the tip 134 and contacts the at least one electronic device 10 arranged in the interior or cavity 124 of the electrically conductive chamber 120.

In some embodiments, a void space is provided between the at least one contact needle 132 extending through the at least one opening 122 and an edge 126 of the at least one opening 122. The void space is understood as a space essentially devoid of matter. In particular, there may not be any other material in the opening 122 between the contact needle 132 and the edge 126 of the opening 122 so that the contact needle 132 is freely moveable within the opening 122.

According to further embodiments, a bridging material can be provided between the at least one contact needle 132 extending through the at least one opening 122 and the edge 126 of the at least one opening 122. In particular, the bridging material may fix the at least one contact needle 132 inside the at least one opening 122 and/or to the edge 126 of the at least one opening 122 so that the at least one contact needle 132 is unmovable within the at least one opening 122. The bridging material may be an electrically insulating material.

In some embodiments, the at least one contact needle 132 can be covered with an insulating material with the tip 134 being exposed. In further embodiments, the at least one contact needle 132 is not covered with any material, such as an insulating material. In other words, an electrically conductive material forming the at least one contact needle 132 can be uncovered and thus exposed.

According to some embodiments, a plurality of openings 122 can be arranged along a circumference of the electrically conductive chamber 120 at regular or irregular intervals. A corresponding contact needle 132 may extend through each opening of the plurality of openings 122. In particular, a number of openings 122 of the electrically conductive chamber 120 can be equal to a number of contact needles 132 of the needle card 130. Alternatively, the number of openings 122 of the electrically conductive chamber 120 can be different from the number of contact needles 132 of the needle card 130, e.g., higher or smaller.

In some embodiments, the at least one opening 122 includes, or is, at least one slot. Preferably, the at least one slot is open towards the base surface 112. A plurality of slots can be arranged along a circumference of the electrically conductive chamber 120 at regular or irregular intervals, forming a comb-like structure.

The electrically conductive chamber 120 may include a lateral chamber wall 128 and a top chamber wall 129 arranged on a first side of the lateral chamber wall 128. A second side of the lateral chamber wall 128 opposite the first side can be arranged to face the base surface 112. The lateral chamber wall 128 and the top chamber wall 129 may define the interior or cavity 124 of the electrically conductive chamber 120. The at least one opening 122 can be provided in the lateral chamber wall 128 and/or the top chamber wall 129.

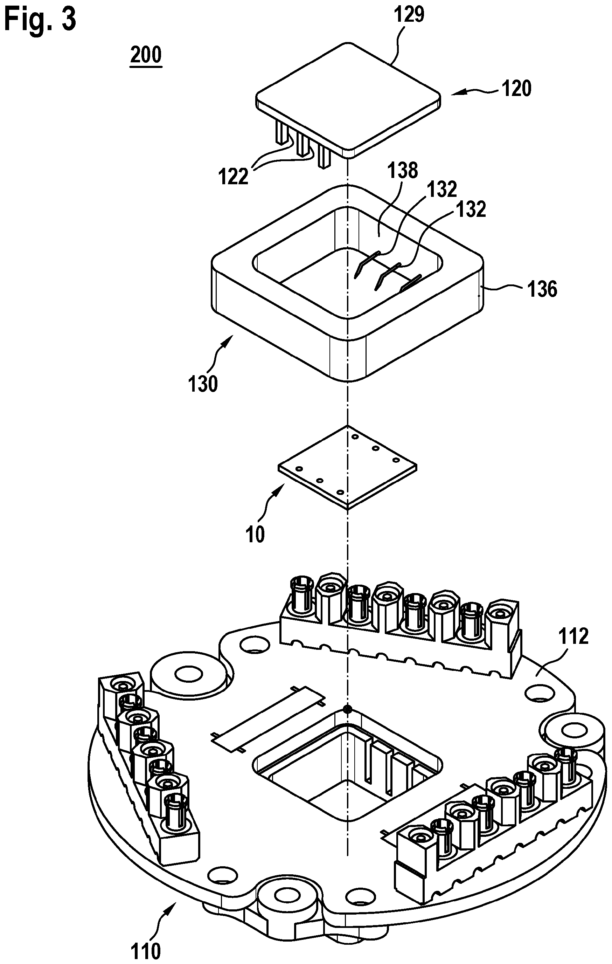

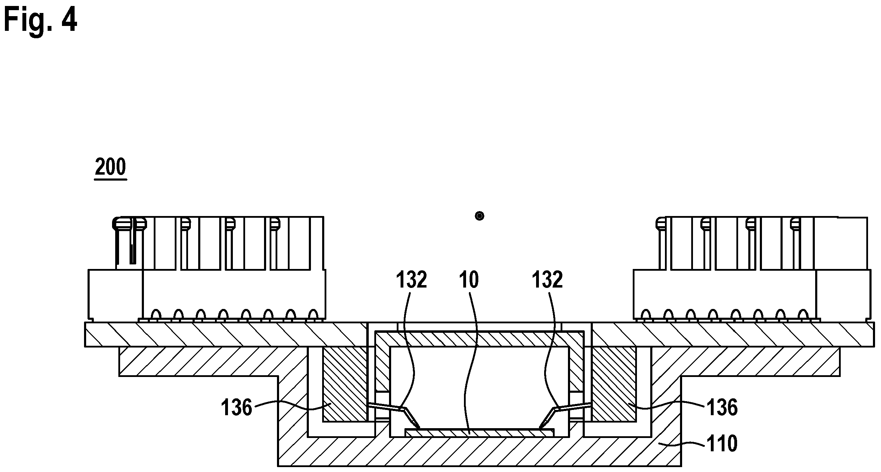

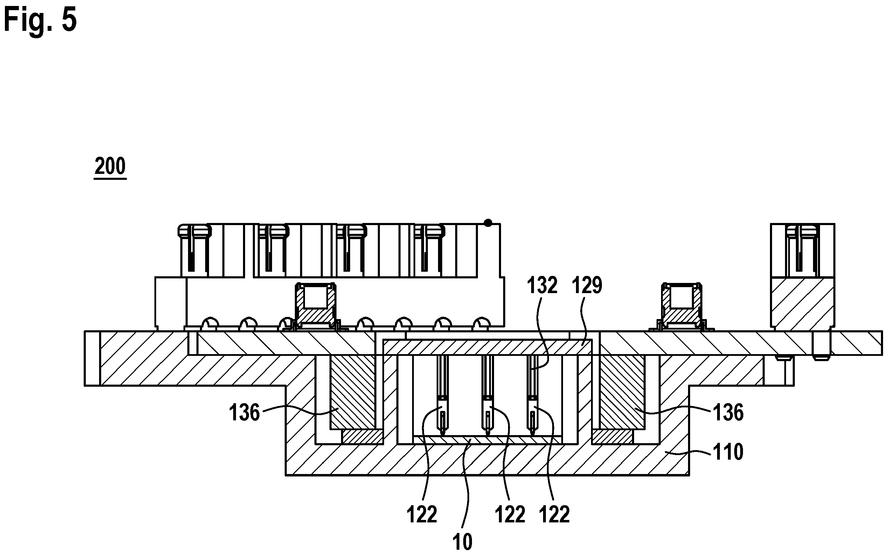

FIG. 3 shows a schematic view of an apparatus 200 for testing and/or operating electronic devices 10 inside a cryogenic apparatus according to further embodiments of the present disclosure. FIG. 4 shows a cross-sectional view of the apparatus of FIG. 3. FIG. 5 shows another cross-sectional view of the apparatus of FIGs. 3 and 4.

The apparatus 200 of FIGs. 3 to 5 is similar to the apparatus 100 of FIG 2, and therefore a description of identical or similar aspects will not be repeated.

The base 110 includes a recess, a bottom of the recess providing the base surface 112 on which the electronic device 10 may be disposed. The recess is further configured to accommodate the needle card 130, particularly the base structure 136, and the electrically conductive chamber 120. For example, when assembled, the base structure 136 may surround the electrically conductive chamber 120. Such an arrangement allows for easy assembling outside of the cryogenic apparatus.

The base structure 136 may include or consist of a ring, such as a ceramic ring. The at least one contact needle 132 may extend from an inner sidewall 138 of the ring. Accordingly, in an assembly process, the electronic device(s) 10 may first be disposed on the base surface 112, and then the ring-shaped base structure 136 may be disposed around the base surface 112. Thereafter, the electrically conductive chamber 120 may be disposed inside the ring-shaped base structure 136 such that the open slots receive the contact needles 132.

By placing the needle card 130 outside of the electrically conductive chamber 120 and guiding the contact needles 132 through the slots in the electrically conductive chamber 120, the electrically conductive chamber 120 can have smaller dimensions that increase an electromagnetic eigenmode of the electrically conductive chamber 120. Additionally, it avoids adding materials of different electromagnetic characteristics for instance inside the cavity, negatively impacting the electromagnetic eigenmode. As a result, signal loss during testing and/or operation of the electronic device(s) 10, particularly in the high frequency and/or low power range, can be avoided.

While the foregoing is directed to embodiments of the disclosure, other and further embodiments of the disclosure may be devised without departing from the basic scope thereof, and the scope thereof is determined by the claims that follow.

**Claims**

1. Apparatus (100, 200) for testing and/or operating electronic devices (10) inside a cryogenic apparatus (1000), comprising:

   a base (110) having a base surface (112) configured to have at least one electronic device (10) arranged thereon;
   an electrically conductive chamber (120) surrounding the base surface (112), the electrically conductive chamber (120) including at least one opening (120) in a chamber wall (128, 129) thereof; and
   a needle card (130) arranged outside of the electrically conductive chamber (120), the needle card (130) including at least one contact needle (132) extending through the at least one opening (122) of the electrically conductive chamber (120), the at least one contact needle (132) being configured for electrical contact with the at least one electronic device (10),
   wherein the electrically conductive chamber (120) has an electromagnetic eigenmode that is larger than a testing and/or operating frequency supplied to the at least one electronic device (10) via the at least one contact needle during testing and/or operating of the at least one electronic device (10).

2. Apparatus (100, 200) of claim 1, wherein:

   the apparatus (100, 200) is connectable to the cryogenic apparatus (1000) for testing and/or operating of the at least one electronic device (10), in particular wherein the apparatus (100, 200) is releasably connectable to the cryogenic apparatus (100); and/or
   the apparatus (100, 200) is configured to be connected to an object holder that is connectable to and/or insertable into the cryogenic apparatus (1000), in particular wherein the apparatus (100, 200) is releasably connectable to the object holder.

3. Apparatus (100, 200) of claim 1 or 2, wherein:

   the electromagnetic eigenmode of the electrically conductive chamber (120) is a lowest possible excitation frequency defined by a geometry of the electrically conductive chamber (120); and/or
   the electromagnetic eigenmode of the electrically conductive chamber (120) is 50GHz or more, 80GHz or more, or 100GHz or more, in particular wherein the electromagnetic eigenmode of the electrically conductive chamber (120) is in a range between 10GHz and 100GHz.

4. Apparatus (100, 200) of any one of claims 1 to 3, wherein the electrically conductive chamber (120) is further configured as an electrical shield to shield the at least one electronic device (10) from external electrical interference, in particular wherein the electrically conductive chamber (120) is configured as a radiofrequency shield.

5. Apparatus (100, 200) of any one of claims 1 to 4, wherein the electrically conductive chamber (120) includes, or is made of, at least one electrically conductive material, in particular wherein the at least one electrically conductive material is selected from the group consisting of aluminum, copper, titanium, and niobium.

6. Apparatus (100, 200) of any one of claims 1 to 5, wherein a void space is provided between the at least one contact needle (132) extending through the at least one opening (122) and an edge (126) of the at least one opening (122).

7. Apparatus (100, 200) of any one of claims 1 to 6, wherein the at least one contact needle (132) is covered with an insulating material with a tip (134) of the at least one contact needle (132) being exposed.

8. Apparatus (100, 200) of any one of claims 1 to 7, wherein the at least one opening (122) of the electrically conductive chamber (120) is a plurality of openings and the at least one contact needle (132) is a plurality of contact needles, wherein each contact needle of the plurality of contact needles (132) extends through a respective opening of the plurality of openings (122).

9. Apparatus (100, 200) of any one of claims 1 to 8, wherein the at least one opening (122) includes, or is, at least one slot in the chamber wall (128), wherein the at least one slot is open at a portion of the chamber wall (128) facing the base surface (112), in particular wherein the at least one slot is a plurality of slots arranged along a circumference of the chamber wall (128), in particular wherein the plurality of slots form a comb-like structure.

10. Apparatus (100, 200) of any one of claims 1 to 9, wherein the chamber wall (128, 129) includes a lateral chamber wall (128) and a top chamber wall (129) arranged on a first side of the lateral chamber wall (128), wherein the lateral chamber wall (128) and the top chamber wall (129) define an interior (124) of the electrically conductive chamber (120), in particular wherein the lateral chamber wall (128) and the top chamber wall (129) define a cup-shape.

11. Apparatus (100, 200) of claim 10, wherein the electrically conductive chamber (120) has an opening at a second side of the lateral chamber wall (128) opposite the first side of the lateral chamber wall (128), in particular wherein the second side of the lateral chamber wall (128) is attached to the base (110) to close off the interior (124) of the electrically conductive chamber (120) and/or the at least one opening (122) is provided in the lateral chamber wall (128) and/or the top chamber wall (129).

12. Apparatus (100, 200) of any one of claims 1 to 11, wherein the needle card (130) includes a base structure (136) arranged outside the electrically conductive chamber (120), wherein the at least one contact needle (132) is attached to the base structure (136) and extends from the base structure (136) through the at least one opening (122) in the chamber wall (128) of the electrically conductive chamber (120), in particular wherein the base structure (136) includes a base ring and the at least one contact needle (132) extends from an inner sidewall (138) of the base ring.

13. Apparatus (100, 200) of any one of claims 1 to 12, wherein the base (110) includes a recess, a bottom of the recess providing the base surface (112), wherein the recess is configured to accommodate the needle card (130) and/or the electrically conductive chamber (120).

14. Apparatus (100, 200) of any one of claims 1 to 13, wherein the at least one electronic device (10) is selected from the group consisting of an integrated circuit, a quantum chip, a wafer, a semiconductor device, a component of an integrated circuit, and a component of quantum chip.

15. Electrically conductive chamber (120) used in testing and/or operating electronic devices (10) inside a cryogenic apparatus (1000), comprising:

a cavity (124) configured to accommodate at least one electronic device (10) therein; and
a chamber wall (128, 129) defining the cavity (124) and having at least one opening (120) configured to receive at least one contact needle (132) of a needle card (130) arranged outside of the electrically conductive chamber (120),
wherein the cavity (124) has an electromagnetic eigenmode that is larger than a testing and/or operating frequency supplied to the at least one electronic device (10) via the at least one contact needle during testing and/or operating of the at least one electronic device (10).

16. Cryogenic system, comprising:

a cryogenic apparatus (1000) including a vacuum chamber (1100), an object stage (1200) in the vacuum chamber (1100), and a cooling arrangement (1300) configured to cool the object stage (1200); and
an apparatus (100, 200) according to any one of claims 1 to 14, wherein the apparatus (100, 200) is connectable to the object stage (1200).

17. Method for testing and/or operating electronic devices (10) inside a cryogenic apparatus (1000), comprising testing and/or operating at least one electronic device (10) mounted to the apparatus (100, 200) of any one of claims 1 to 14.

# Fig. 1

# Fig. 2

<u>100</u>

**Fig. 3**

200

129

120

122

138

132

132

136

130

10

112

110

EP 4 439 101 A1

Fig. 4

Fig. 5

Europäisches
Patentamt

European
Patent Office

Office européen
des brevets

**EUROPEAN SEARCH REPORT**

Application Number

EP 23 16 5782

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/064784 A1 (CAUDILL JASON C [US] ET AL) 18 March 2010 (2010-03-18) * abstract; claims 1-31; figures 1-12B * * paragraph [0007] - paragraph [0033] * * paragraph [0049] - paragraph [0102] * | 1-17 | INV. G01R31/319 G01R31/28 G01R29/08 |
| X | US 2021/190857 A1 (KIM GYUNG JIN [KR]) 24 June 2021 (2021-06-24) * abstract; claims 1-15; figures 1-14 * * paragraph [0009] - paragraph [0014] * * paragraph [0025] - paragraph [0113] * | 1-17 | |
| X | US 2010/052717 A1 (LOU CHOON LEONG [TW]) 4 March 2010 (2010-03-04) * abstract; claims 1-25; figures 1,2 * * paragraph [0010] - paragraph [0013] * * paragraph [0018] - paragraph [0025] * | 1-17 | |
| X | US 5 459 408 A (CHEN MEN-CHEE [US]) 17 October 1995 (1995-10-17) * abstract; claims 1-8; figures 1-4 * * column 1, line 64 - column 2, line 56 * * column 3, line 9 - column 4, line 46 * | 1-17 | TECHNICAL FIELDS SEARCHED (IPC) G01R |
| X | EP 3 734 304 A1 (AFORE OY [FI]; BLUEFORS CRYOGENICS OY [FI]) 4 November 2020 (2020-11-04) * abstract; claims 1-11; figures 1-3 * * paragraph [0006] * * paragraph [0008] - paragraph [0033] * * paragraph [0037] - paragraph [0042] * | 1-17 | |
| X | US 4 115 736 A (TRACY JOHN M) 19 September 1978 (1978-09-19) * abstract; claims 1-8; figures 1-3 * * column 1, line 48 - column 2, line 52 * * column 3, line 4 - column 4, line 53 * | 1-17 | |

The present search report has been drawn up for all claims

| Place of search | Date of completion of the search | Examiner |
|---|---|---|
| Munich | 11 September 2023 | Nadal, Rafael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                      

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 5782

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2023

| Patent document cited in search report | | | Publication date | Patent family member(s) | | | Publication date |
|---|---|---|---|---|---|---|---|
| US 2010064784 | A1 | | 18-03-2010 | CN | 101685105 | A | 31-03-2010 |
| | | | | EP | 2159580 | A1 | 03-03-2010 |
| | | | | JP | 5501697 | B2 | 28-05-2014 |
| | | | | JP | 2010056553 | A | 11-03-2010 |
| | | | | US | 2010064784 | A1 | 18-03-2010 |
| US 2021190857 | A1 | | 24-06-2021 | CN | 113109687 | A | 13-07-2021 |
| | | | | DE | 102020210704 | A1 | 24-06-2021 |
| | | | | KR | 20210081729 | A | 02-07-2021 |
| | | | | US | 2021190857 | A1 | 24-06-2021 |
| | | | | US | 2023122944 | A1 | 20-04-2023 |
| US 2010052717 | A1 | | 04-03-2010 | JP | 2010060555 | A | 18-03-2010 |
| | | | | TW | 201011298 | A | 16-03-2010 |
| | | | | US | 2010052717 | A1 | 04-03-2010 |
| US 5459408 | A | | 17-10-1995 | DE | 69128052 | T2 | 14-05-1998 |
| | | | | EP | 0470521 | A2 | 12-02-1992 |
| | | | | JP | H0697246 | A | 08-04-1994 |
| | | | | KR | 920005292 | A | 28-03-1992 |
| | | | | TW | 212828 | B | 11-09-1993 |
| | | | | US | 5309088 | A | 03-05-1994 |
| | | | | US | 5459408 | A | 17-10-1995 |
| EP 3734304 | A1 | | 04-11-2020 | NONE | | | |
| US 4115736 | A | | 19-09-1978 | NONE | | | |

EPO FORM P0459

For more details about this annex : see Official Journal of the European Patent Office, No. 12/82